# EUROPEAN PATENT SPECIFICATION

(11) **EP 4 362 619 B1**
(45) Date of publication and mention of the grant of the patent: **18.11.2026**
(21) Application number: 22203848.1
(22) Date of filing: 26.10.2022
(51) Int. Cl.: H05K 7/20

(54) **ELECTRIC POWER CONVERTER**
LEISTUNGSELEKTRONISCHER UMRICHTER
CONVERTISSEUR ÉLECTRONIQUE DE PUISSANCE

(43) Date of publication of application: 01.05.2024
(73) Proprietor: MAHLE International GmbH, 70376 Stuttgart (DE)
(72) Inventor: Stolfa, Danijel, 5250 Solkan (SI); Verdev, Luka, 3320 Velenje (SI); Cimzar, Blaz, 4205 Preddvor (SI)

(56) References cited:
- EP-A1- 3 609 068
- EP-A2- 2 897 274

## Description

### TECHNICAL FIELD

The invention relates to an electric control unit according to the preamble of independent claim 1.

### BACKGROUND ART

An electronic power inverter for an electrical machine is known for example in EP3609068B1. The power inverter comprises a housing with a semiconductor board, a capacitor board, power terminals and phase terminal studs. The capacitors of the capacitor board are received in recesses of a heat exchanger plate. The phase terminal studs rest on contacts of the semiconductor board and are biased towards the contacts of the semiconductor board by a pressing plate via the capacitor board and a damping plate. Also EP2897274A2 discloses an electronic power inverter.

### SUMMARY

The electronic control unit according to the invention as defined in claim 1 has the advantage that a risk of overheating of the phase terminals can be reduced, thus preventing damage to the electronic control unit.

This is achieved according to a first aspect of the invention with an electronic control unit for an electrical machine of an electrically powered drive system, the electric control unit comprising at least one semiconductor board having a plurality of power semiconductors, a baseplate for dissipating heat generated in the electronic control unit, power terminals for supplying power to the electronic control unit, a plurality of phase terminals for supplying three phase current to the electric machine, wherein the phase terminals are connected to terminal contacts on the at least one semiconductor board. At least one of the phase terminals comprises a first stud for electrical connection to field windings of the electric machine, the first stud extending in a direction away from the baseplate, and a second stud for connecting the phase terminal to one of the terminal contacts on the at least one semiconductor board, wherein the first and second stud are electrically connected via a connecting part, and the second stud extends into a recess in the baseplate.

Heat is generated in the area of connection of the phase terminal with the semiconductor board, and by providing this connection in the form of a stud which extends into a recess in the baseplate, heat can be efficiently transferred away from the area of the connection into the baseplate.

The baseplate can be a plate of cast aluminium, in which the recess is machined into. The baseplate preferably comprises heat dissipating fins and/or pins on a side facing away from semiconductor board.

The first stud, the second stud and the connection part are integrally formed in one piece out of metal. The number of connection points between a phase connection point on the semiconductor board and the field windings are therefore reduced, reducing sources of heat generation.

The first studs of the plurality of phase terminals and the power terminals are preferably arranged linearly adjacent to the semiconductor board when viewed in the stacking direction.

For the case that each phase terminal is connected to two terminal contacts on the semiconductor board, for example when the phase terminal is connected to two bridge arms of an inverter, the phase terminal can comprise a third stud for connecting the phase terminal to one of the terminal contacts on the at least one semiconductor board, wherein the second and third studs are electrically connected via a second connecting part, and the third stud also extends into a recess in the baseplate.

The recess in the baseplate can be a single recess into which the second and third studs extend. Alternatively there can be a plurality of separate recesses, one for each of the second and/or third studs.

The side walls of the respective recess are arranged in close proximity to the stud surface without contacting the stud surface. Heat can therefore be effectively transferred from the phase terminals to the baseplate by conduction. For this purpose, the gap between the stud surface and the baseplate in the area of the recess can be filled with a thermally conductive gap filling potting material.

The second stud is provided with a threaded hole and the second stud is attached to a side of the at least one semiconductor board facing the baseplate via a screw which extends through the semiconductor board into the threaded hole. The third stud can be similarly provided with a threaded hole and is attached to a side of the at least one semiconductor board facing the baseplate via a screw which extends through the semiconductor board into the threaded hole. The phase terminals are thus firmly attached to the electrical contact on the semiconductor board to minimize resistance and reduce heat generation.

The first studs can also be provided with a threaded hole for screw attachment of field windings.

A plurality of capacitors can also be connected to the semiconductor board and arranged on a side of the semiconductor board facing the baseplate, wherein the plurality of capacitors are received in recessed portion of the baseplate. The capacitors can be arranged in the same recess as the second or third phase terminal studs. Alternatively, the capacitors can be arranged in recesses separate from the recesses of the second or third phase terminal studs.

The electronic control unit can further comprise a holding bracket and resilient biasing means for biasing the power semiconductors towards the baseplate, wherein the holding bracket comprises means for attaching the resilient biasing means to holding bracket, and the holding bracket is attached to the baseplate. When the holding bracket is attached to the baseplate, the resilient means are sandwiched in the stacking direction between the holding bracket and the power semiconductors and bias the power semiconductors towards the baseplate to improve heat transfer away from the power semiconductors. The resilient biasing means can comprise a plurality of leaf springs.

### BRIEF DESCRIPTION OF THE DRAWINGS

Embodiments will now be described by way of example only with reference to the accompanying drawings, in which:
Figure 1 is a perspective view of an electronic control unit according to the invention
Figure 2 is an exploded view of the electronic control unit in fig. 1.

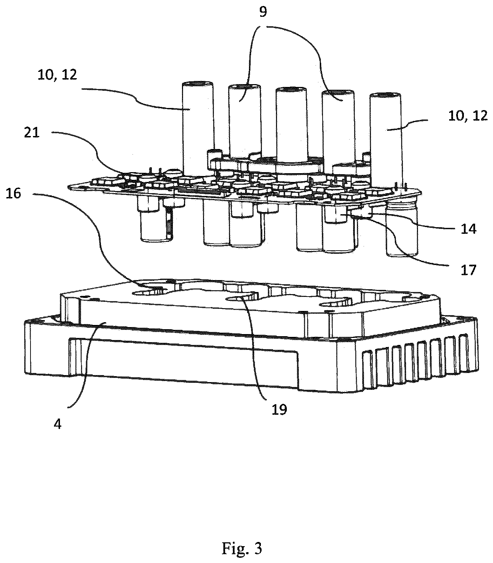

Figure 3 is an exploded view of part of the electronic control unit in fig. 1.

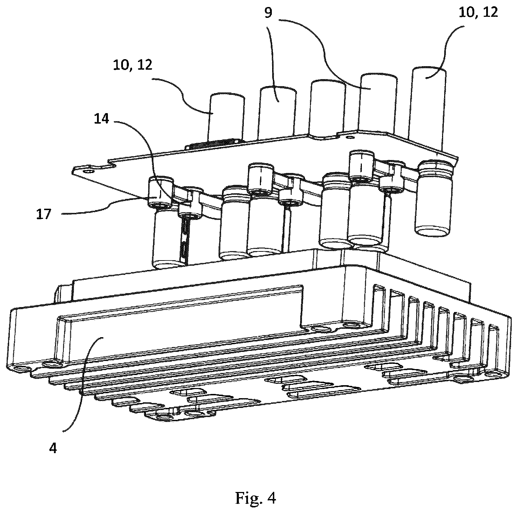

Figure 4 is an exploded view from below of part of the electronic control unit in fig. 1.
Figure 5 is a cross-section view of the electronic control unit in fig. 1.
Figure 6 is a perspective view of a phase terminal according to the invention

### DETAILED DESCRIPTION

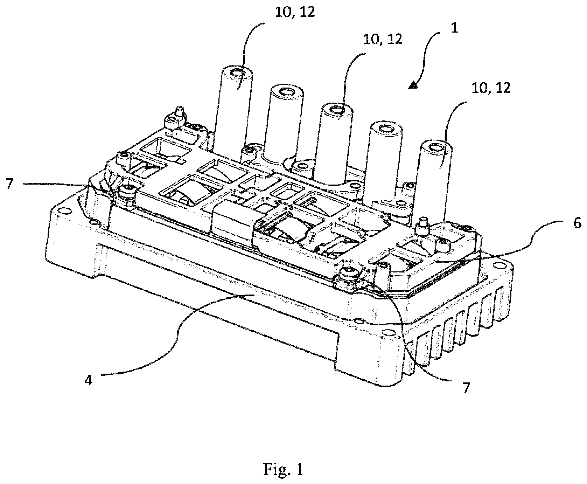

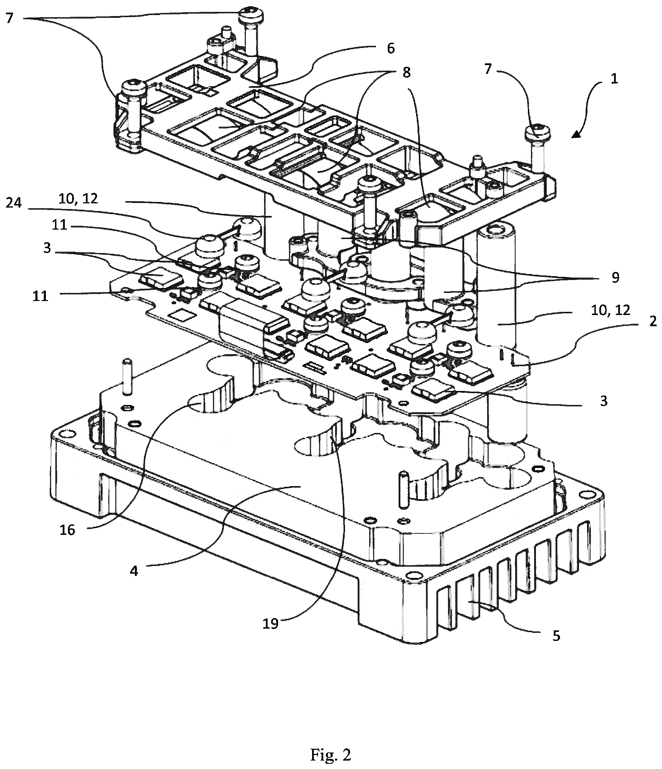

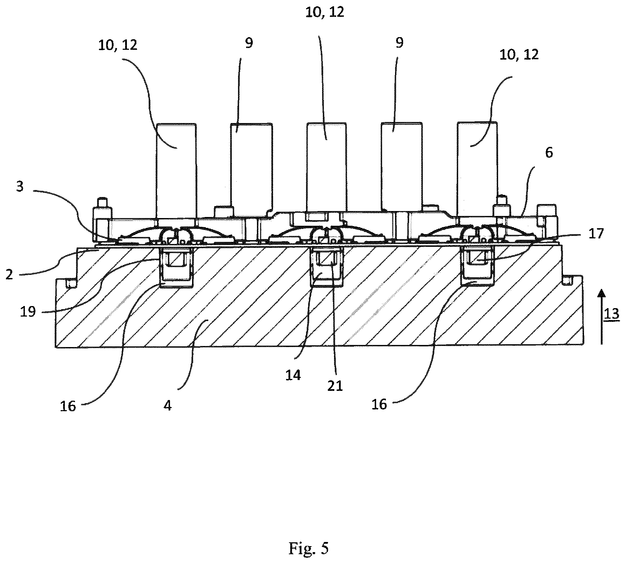

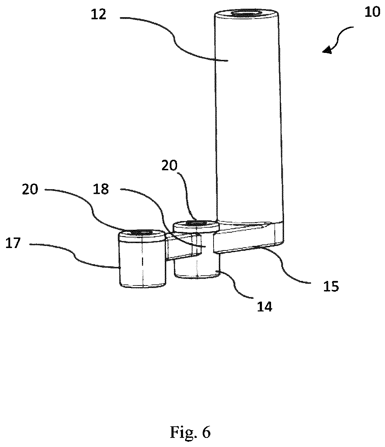

With reference to the drawings, figures 1 and 2 show an electronic control unit 1 according to the invention. The electronic control unit 1 can be used for example as an inverter for an electrical machine of an electrically powered drive system. The electronic control unit 1 comprises at least one semiconductor board 2 having a plurality of power semiconductors 3 and a baseplate 4 for dissipating heat generated in the electronic control unit 1. The electronic control unit 1 further comprises power terminals 9 for supplying power to the electronic control unit 1 and a plurality of phase terminals 10 for supplying three phase current to the electric machine. The phase terminals 10 are connected to terminal contacts 11 on the at least one semiconductor board 2. Figure 6 shows one of the phase terminals 10. The phase terminal 10 comprises a first stud 12 for electrical connection to field windings of an electric machine (not shown). As can be seen in figure 5 the first studs 12 extend in a direction away from the baseplate 4 and are positioned above the baseplate 4 in the stacking direction 13. The stacking direction 13 is the direction in which the semiconductor board 2 is stacked upon the baseplate 4.

The first studs 12 of the plurality of phase terminals 10 and the power terminals 9 are arranged in a line adjacent to the semiconductor board 2 when viewed in the stacking direction 13.

The phase terminal 10 comprises a second stud 14 for connecting the phase terminal 10 to one of the terminal contacts 11 on the semiconductor board 2. The first and second studs 12, 14 are electrically connected via a connecting part 15. The first stud 12, the second stud 14 and the connection part 15 are integrally formed in one piece out of metal.

According to the invention the second stud 14 extends into a recess 16 in the baseplate 4. Heat generated in the area of connection of the phase terminal 10 with the semiconductor board 2 can therefore be efficiently transferred away from the area of the connection via conduction from the second stud 14 into the baseplate.

The baseplate 4 can be a plate or block of cast aluminium, in which the recess 16 is machined into. The baseplate 4 preferably comprises heat dissipating fins 5 and/or pins on a side facing away from semiconductor board 2.

In the embodiment shown in the figures each phase terminal 10 is connected to two terminal contacts 11 on the semiconductor board 2. This is necessary for example when the phase terminal 10 is connected to two bridge arms of an inverter. In this case the phase terminal 10 has a third stud 17 for connecting the phase terminal 10 to one of the terminal contacts 11 on the at least one semiconductor board 2. The second and third studs 14, 17 are electrically connected via a second connecting part 18, and the third stud 17 also extends into a recess 16 in the baseplate 4.

The recess 16 in the baseplate 4 in the embodiment shown is a single recess 16 into which the second and third studs 14, 17 extend in the stacking direction 13. Alternatively there can be a plurality of separate recesses 16, one for each of the second and/or third studs 14, 17, or a plurality of recesses 16 which each contain a plurality of second and/or third studs 14, 17 respectively.

As can be seen in figure 5, portions of the side walls 19 of the respective recess 16 are arranged in close proximity to the stud surface of the second and/or third studs 14, 17 without contacting the stud surface. Heat can therefore be effectively transferred from the phase terminals 10 to the baseplate 4. For this purpose the recess can be filled with a heat conducting filler material to facilitate the conduction of heat away from the studs 14, 17 into the baseplate 4. The second and third studs 14, 17 have a generally cylindrical shape.

The space between the recess 16 and the second and third studs 14, 17 can be filled with a potting substance, for example a silicone gel, in order to improve heat transfer away from the phase terminal 10.

The second and third studs 14, 17 are each provided with a threaded hole 20 and the second and third studs 14, 17 are attached to a side of the at least one semiconductor board 2 facing the baseplate 4 via a screw 21 which extends through the semiconductor board 2 into the threaded hole 20. The phase terminals 10 are thus firmly attached to the terminal contact 11 on the semiconductor board 2 to minimize resistance and reduce heat generation. The heads of the screws 21 can be covered with an insulation cap 24, preferably made out of plastic, to prevent contact with other parts of the electronic control device 1, in particular to prevent electrical contact between the heads of the screws 21 and a holding bracket 6 which can be made out of aluminium.

The first studs are also be provided with a threaded hole 22 for screw attachment of field windings.

A plurality of capacitors 23 are connected to the semiconductor board and arranged on a side of the semiconductor board 2 facing the baseplate 4, wherein the plurality of capacitors 23 are received in a recessed portion 16 of the baseplate 4. The capacitors 23 can be arranged in the same recess as the second or third phase terminal studs 14, 17. Alternatively, the capacitors 23 can be arranged in recesses separate from the recesses 16 of the second or third phase terminal studs 14, 17.

The electronic control unit 1 has a holding bracket 6, preferably made out of alumium, and resilient biasing means 8 for biasing the power semiconductors 3 towards the baseplate 4, wherein the holding bracket 6 comprises means for attaching the resilient biasing means 8 to holding bracket 6, and the holding bracket 6 is attached to the baseplate 4 via screws 7. When the holding bracket 6 is attached to the baseplate 4, the resilient means 8 are sandwiched in the stacking direction between the holding bracket 6 and the power semiconductors 3 and bias the power semiconductors 3 towards the baseplate 4 to improve heat transfer away from the power semiconductors 3. The resilient biasing means can comprise a plurality of leaf springs 8.

### LIST OF REFERENCE NUMERALS

- 1.: Electronic control unit
- 2.: Semiconductor board
- 3.: Power semiconductors
- 4.: Baseplate
- 5.: Cooling fins
- 6.: Holding bracket
- 7.: Screws
- 8.: Leaf spring
- 9.: Power terminal
- 10.: Phase terminal
- 11.: Terminal contact
- 12.: First stud
- 13.: Stacking direction
- 14.: Second stud
- 15.: Connecting part
- 16.: Recess
- 17.: Third stud
- 18.: Second connecting part
- 19.: Side wall
- 20.: Threaded hole
- 21.: Screw
- 22.: Threaded hole
- 23.: Capacitors
- 24.: Insulation cap

## Claims

1. Electronic control unit (1) for an electrical machine of an electrically powered drive system, the electronic control unit (1) comprising at least one semiconductor board (2) having a plurality of power semiconductors (3), a baseplate (4) for dissipating heat generated in the electronic control unit, power terminals (9) for supplying power to the electronic control unit, a plurality of phase terminals (10) for supplying three phase current to the electric machine, wherein the phase terminals (10) are connected to terminal contacts (11) on the at least one semiconductor board (2),
wherein at least one of the phase terminals (10) comprises:
- a first stud (12) for electrical connection to field windings of the electric machine, the first stud (12) extending in a direction away from the baseplate (4),
- a second stud (14) for connecting the phase terminal (10) to one of the terminal contacts (11) on the at least one semiconductor board (2), wherein the first and second stud (12, 14) are electrically connected via a connecting part (15), **characterized in that** the second stud (14) extends into a recess (16) in the baseplate (4).

2. Electronic control unit (1) according to claim 1, wherein the first stud (12), the second stud (14) and the connection part (15) are integrally formed in one piece out of metal.

3. Electronic control unit (1) according to claim 1, wherein the phase terminal (10) further comprises a third stud (17) for connecting the phase terminal (10) to one of the terminal contacts (11) on the at least one semiconductor board (2), wherein the second and third studs (14, 17) are electrically connected via a second connecting part (18), and the third stud extends into a recess (16) in the baseplate (4).

4. Electronic control unit (1) according to claims 1, 2 or 3, wherein the second and/or third studs (14, 17) extend into the recess (16), wherein side walls (19) of the respective recess are arranged in close proximity to the stud surface without contacting the stud surface.

5. Electronic control unit (1) according to one of the preceding claims, wherein the second stud is provided with a threaded hole and the second stud is attached to a side of the at least one semiconductor board (2) facing the baseplate (4) via a screw (7) which extends through the semiconductor board (2) into the threaded hole.

6. Electronic control unit (1) according to one of the preceding claims, wherein a plurality of capacitors are connected to the semiconductor board (2) and are arranged on a side of the semiconductor board (2) facing the baseplate (4), wherein the plurality of capacitors are received in recessed portion (16) of the baseplate (4).

7. Electronic control unit (1) according to one of the preceding claims, further comprising a holding bracket (6) and resilient biasing means (8) for biasing the power semiconductors (3) towards the baseplate (4), wherein the holding bracket (6) comprises means for attaching the resilient biasing means (8) to holding bracket (6), and the holding bracket (6) is attached to the baseplate (4).

8. Electronic control unit (1) according to claim 7, wherein the resilient biasing means (8) comprises a plurality of leaf springs (8).

9. Electronic control unit (1) according to one of the preceding claims, wherein the baseplate (4) comprises heat dissipating fins and/or pins (5) on a side facing away from semiconductor board (2).

## Patentansprüche

1. Elektronische Steuerungseinheit (1) für eine elektrische Maschine eines elektrisch mit Leistung versorgten Antriebssystems, die elektronische Steuerungseinheit (1) umfassend mindestens eine Halbleiterplatine (2), die eine Vielzahl von Leistungshalbleitern (3), eine Grundplatte (4) zum Ableiten von Wärme, die in der elektronischen Steuerungseinheit erzeugt wird, Leistungsanschlüsse (9) zum Zuführen von Leistung zu der elektronischen Steuerungseinheit, eine Vielzahl von Phasenanschlüssen (10) zum Zuführen von Dreiphasenstrom zu der elektrischen Maschine aufweist, wobei die Phasenanschlüsse (10) mit Anschlusskontakten (11) auf der mindestens einen Halbleiterplatine (2) verbunden sind, wobei mindestens einer der Phasenanschlüsse (10) umfasst:
- einen ersten Bolzen (12) für eine elektrische Verbindung mit Feldwicklungen der elektrischen Maschine, wobei sich der erste Bolzen (12) in eine Richtung weg von der Grundplatte (4) erstreckt,
- einen zweiten Bolzen (14) zum Verbinden des Phasenanschlusses (10) mit einem der Anschlusskontakte (11) auf der mindestens einen Halbleiterplatine (2), wobei der erste und der zweite Bolzen (12, 14) über ein verbindendes Teil (15) elektrisch verbunden sind, **dadurch gekennzeichnet, dass** sich der zweite Bolzen (14) in eine Aussparung (16) in der Grundplatte (4) erstreckt.

2. Elektronische Steuerungseinheit (1) nach Anspruch 1, wobei der erste Bolzen (12), der zweite Bolzen (14) und das Verbindungsteil (15) in einem Stück aus Metall einstückig ausgebildet sind.

3. Elektronische Steuerungseinheit (1) nach Anspruch 1, wobei der Phasenanschluss (10) ferner einen dritten Bolzen (17) zum Verbinden des Phasenanschlusses (10) mit einem der Anschlusskontakte (11) auf der mindestens einen Halbleiterplatine (2) umfasst, wobei der zweite und der dritte Bolzen (14, 17) über ein zweites verbindendes Teil (18) elektrisch verbunden sind und sich der dritte Bolzen in eine Aussparung (16) in der Grundplatte (4) erstreckt.

4. Elektronische Steuerungseinheit (1) nach den Ansprüchen 1, 2 oder 3, wobei sich der zweite und/oder der dritte Bolzen (14, 17) in die Aussparung (16) erstrecken, wobei Seitenwände (19) der jeweiligen Aussparung in unmittelbarer Nähe zu der Bolzenoberfläche angeordnet sind, ohne die Bolzenoberfläche zu kontaktieren.

5. Elektronische Steuerungseinheit (1) nach einem der vorstehenden Ansprüche, wobei der zweite Bolzen mit einer Gewindebohrung versehen ist und der zweite Bolzen an einer Seite der mindestens einen Halbleiterplatine (2), die der Grundplatte (4) zugewandt ist, über eine Schraube (7) befestigt ist, die sich durch die Halbleiterplatine (2) in die Gewindebohrung erstreckt.

6. Elektronische Steuerungseinheit (1) nach einem der vorstehenden Ansprüche, wobei eine Vielzahl von Kondensatoren mit der Halbleiterplatine (2) verbunden und auf einer Seite der Halbleiterplatine (2) angeordnet sind, die der Grundplatte (4) zugewandt ist, wobei die Vielzahl von Kondensatoren in einem ausgesparten Abschnitt (16) der Grundplatte (4) aufgenommen sind.

7. Elektronische Steuerungseinheit (1) nach einem der vorstehenden Ansprüche, ferner umfassend einen Haltebügel (6) und ein elastisches Vorspannmittel (8) zum Vorspannen der Leistungshalbleiter (3) zu der Grundplatte (4) hin, wobei der Haltebügel (6) ein Mittel zum Befestigen des elastischen Vorspannmittels (8) an dem Haltebügel (6) umfasst und der Haltebügel (6) an der Grundplatte (4) befestigt ist.

8. Elektronische Steuerungseinheit (1) nach Anspruch 7, wobei das elastische Vorspannmittel (8) eine Vielzahl von Blattfedern (8) umfasst.

9. Elektronische Steuerungseinheit (1) nach einem der vorstehenden Ansprüche, wobei die Grundplatte (4) wärmeableitende Rippen und/oder Stifte (5) auf einer Seite umfasst, die von der Halbleiterplatine (2) abgewandt ist.

## Revendications

1. Unité de commande électronique (1) pour une machine électrique d'un système d'entraînement à alimentation électrique, l'unité de commande électronique (1) comprenant au moins une carte à semi-conducteurs (2) présentant une pluralité de semi-conducteurs de puissance (3), une plaque de base (4) pour dissiper la chaleur générée dans l'unité de commande électronique, des bornes de puissance (9) pour fournir de l'énergie à l'unité de commande électronique, une pluralité de bornes de phase (10) pour fournir un courant triphasé à la machine électrique, dans laquelle les bornes de phase (10) sont connectées à des contacts de borne (11) sur l'au moins une carte à semi-conducteurs (2), dans laquelle au moins l'une parmi les bornes de phase (10) comprend :
- un premier plot (12) pour la connexion électrique aux enroulements inducteurs de la machine électrique, le premier plot (12) s'étendant dans une direction s'éloignant de la plaque de base (4),
- un deuxième plot (14) pour connecter la borne de phase (10) à l'un des contacts de borne (11) sur l'au moins une carte à semi-conducteur (2), dans laquelle les premier et deuxième plots (12, 14) sont connectés électriquement par l'intermédiaire d'une pièce de connexion (15), **caractérisée en ce que** le deuxième plot (14) s'étend dans un évidement (16) dans la plaque de base (4).

2. Unité de commande électronique (1) selon la revendication 1, dans laquelle le premier plot (12), le deuxième plot (14) et la partie de connexion (15) sont formés d'un seul tenant en métal.

3. Unité de commande électronique (1) selon la revendication 1, dans laquelle la borne de phase (10) comprend en outre un troisième plot (17) pour connecter la borne de phase (10) à l'un des contacts de borne (11) sur l'au moins une carte à semi-conducteur (2), dans laquelle les deuxième et troisième plots (14, 17) sont connectés électriquement par l'intermédiaire d'une seconde partie de connexion (18), et le troisième plot s'étend dans un évidement (16) dans la plaque de base (4).

4. Unité de commande électronique (1) selon les revendications 1, 2 ou 3, dans laquelle les deuxième et/ou troisième plots (14, 17) s'étendent dans l'évidement (16), dans laquelle des parois latérales (19) de l'évidement respectif sont agencées à proximité immédiate de la surface du plot sans contact avec la surface du plot.

5. Unité de commande électronique (1) selon l'une des revendications précédentes, dans laquelle le deuxième plot est pourvu d'un trou fileté et le deuxième plot est fixé à un côté de l'au moins une carte à semi-conducteur (2) faisant face à la plaque de base (4) par l'intermédiaire d'une vis (7) qui s'étend à travers la carte à semi-conducteur (2) jusque dans le trou fileté.

6. Unité de commande électronique (1) selon l'une des revendications précédentes, dans laquelle une pluralité de condensateurs sont connectés à la carte à semi-conducteur (2) et sont agencés sur un côté de la carte à semi-conducteur (2) faisant face à la plaque de base (4), dans laquelle la pluralité de condensateurs sont reçus dans une partie évidée (16) de la plaque de base (4).

7. Unité de commande électronique (1) selon l'une des revendications précédentes, comprenant en outre un support de maintien (6) et un moyen de polarisation élastique (8) pour polariser les semi-conducteurs de puissance (3) vers la plaque de base (4), dans laquelle le support de maintien (6) comprend un moyen pour fixer le moyen de polarisation élastique (8) au support de maintien (6), et le support de maintien (6) est fixé à la plaque de base (4).

8. Unité de commande électronique (1) selon la revendication 7, dans laquelle le moyen de polarisation élastique (8) comprend une pluralité de ressorts à lames (8).

9. Unité de commande électronique (1) selon l'une des revendications précédentes, dans laquelle la plaque de base (4) comprend des ailettes et/ou des broches de dissipation thermique (5) sur un côté opposé à la carte à semi-conducteurs (2).
